# EUROPÄISCHE PATENTANMELDUNG

(11) **EP 1 235 274 A1**
(43) Veröffentlichungstag der Anmeldung: **28.08.2002**
(21) Anmeldenummer: 01106863.2
(22) Anmeldetag: 20.03.2001
(51) Int. Cl.: H01L 23/467, H05K 7/20, G06F 1/20

(54) **Temperatur-Überwachungsvorrichtung für Mikroprozessor-Kühleinrichtungen**

(30) Priorität: 15.02.2001 DE 10107492
(71) Anmelder: SEESEMANN, MATTHIAS, 61273 WEHRHEIM (DE)
(72) Erfinder: SEESEMANN, MATTHIAS, 61273 WEHRHEIM (DE)
(74) Vertreter: Kiessling, Christian

(57) **Zusammenfassung**

Bei einer Temperatur-Überwachungsvorrichtung für Mikroprozessoren, mit einer Ventilatoreinrichtung zum Erzeugen eines Luftstromes zum Kühlen des Mikroprozessors wird dadurch, dass die Temperatur des Mikroprozessors mittels eines im Bereich von dessen Oberfläche angebrachten Wärmemesswiderstandes sensierbar ist und eine Regelungsschaltung vorgesehen ist, die aufgrund der von dem Wärmemesswiderstand sensierten Temperatur die Geschwindigkeit der Ventilatoreinrichtung mit steigender Temperatur erhöht und mit sinkender Temperatur mindert, wobei zusätzlich eine Drehzahlüberwachungseinrichtung zum Überwachen eines vorgebbaren Drehzahlbereiches der Ventilatoreinrichtung vorgesehen ist, die im Zusammenwirken mit einer elektronischen Schaltung ein Warnsignal abgibt, um einen Benutzer einer mit der Mikroprozessor betriebenen Vorrichtung zum manuellen Abschalten derselben aufzufordern, wenn der vorgegebene Drehzahlbereich der Ventilatoreinrichtung verlassen ist, erreicht, dass eine Überhitzung eines Mikroprozessors wirksam verhindert ist.

## Beschreibung

Die Erfindung betrifft eine Temperatur-Überwachungsvorrichtung für Mikroprozessoren, mit einer Ventilatoreinrichtung zum Erzeugen eines Luftstromes zum Kühlen des Mikroprozessors. Die erfindungsgemäße Temperatur-Überwachungsvorrichtung kann des weiteren für Desktopp PC's oder ähnliche, temperaturempfindliche Vorrichtungen verwendet werden.

Temperatur-Überwachungsvorrichtung der eingangs genannten Art sind im Stand der Technik bekannt. Die bekannten Temperatur-Überwachungsvorrichtungen weisen jedoch insgesamt den Nachteil auf, dass Ausfälle von Mikroprozessoren wegen Überhitzung nicht effektiv vermieden werden können.

Aufgabe der Erfindung ist es deshalb, eine Temperatur-Überwachungsvorrichtung für Mikroprozessoren zu schaffen, mittels derer eine Überhitzung eines Mikroprozessors wirksam verhindert werden kann.

Für eine Temperatur-Überwachungsvorrichtung der eingangs genannten Art wird diese Aufgabe dadurch gelöst, dass die Temperatur des Mikroprozessors mittels eines im Bereich von dessen Oberfläche angebrachten Wärmemesssensor sensierbar ist, und eine Regelungsschaltung vorgesehen ist, die aufgrund der von dem Wärmemesssensor sensierten Temperatur die Geschwindigkeit der Ventilatoreinrichtung mit steigender Temperatur erhöht und mit sinkender Temperatur mindert, wobei zusätzlich eine Drehzahlüberwachungseinrichtung zum Überwachen eines vorgebbaren Drehzahlbereiches der Ventilatoreinrichtung vorgesehen ist, die im Zusammenwirken mit einer elektronischen Schaltung ein Warnsignal abgibt, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist.

Bevorzugte Ausführungsformen der Erfindung sind Gegenstand der Unteransprüche.

Bei der erfindungsgemäßen Temperatur-Überwachungsvorrichtung wird durch das Merkmal, dass die Temperatur des Mikroprozessors mittels eines im Bereich von dessen Oberfläche angebrachten Wärmemesssensor sensierbar ist, und eine Regelungsschaltung vorgesehen ist, die aufgrund der von dem Wärmemesssensor sensierten Temperatur die Geschwindigkeit der Ventilatoreinrichtung mit steigender Temperatur erhöht und mit sinkender Temperatur mindert, wobei zusätzlich eine Drehzahlüberwachungseinrichtung zum Überwachen eines vorgebbaren Drehzahlbereiches der Ventilatoreinrichtung vorgesehen ist, die im Zusammenwirken mit einer elektronischen Schaltung ein Warnsignal abgibt, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist, erreicht, dass eine Vorrichtung geschaffen ist, bei der für den Fall, dass eine ausreichende Kühlung mittels der Regelungseinrichtung allein beispielsweise bei Nichtfunktion oder Schlechtfunktion der Ventilatoreinrichtung nicht sichergestellt werden kann, eine weitere Überwachungseinrichtung vorgesehen ist, mittels derer eine Überhitzung des Mikroprozessors sicher vermeidbar ist.

Gemäß einer ersten bevorzugten Ausführungsform der erfindungsgemäßen Vorrichtung ist vorgesehen, dass der die Temperatur des Mikroprozessors sensierende Wärmemesssensor in einer in dem Boden eines Kühlkörpers des Mikroprozessors ausgebildeten Bohrung angeordnet ist. Die Ventilatoreinrichtung ist dabei vorzugsweise an dem Kühlkörper des Mikroprozessors angeordnet.

Gemäß einer anderen bevorzugten Ausführungsform der erfindungsgemäßen Vorrichtung ist vorgesehen, dass die Drehzahlüberwachungseinrichtung zum Überwachen eines vorgebbaren Drehzahlbereiches der Ventilatoreinrichtung eine Einrichtung enthält, die ein mit der Umdrehungsfrequenz des Ventilators der Ventilatoreinrichtung getaktetes Stroboskopsignal liefert, sowie eine mit einer vorgegebenen Frequenz getaktete Einrichtung zum Auswerten des Stroboskopsignals enthält.

Gemäß einer weiteren bevorzugten Ausführungsform der erfindungsgemäßen Vorrichtung ist vorgesehen, dass die Ventilatoreinrichtung dimensioniert ist, um in der Lage zu sein, eine Luftmenge etwa 80 m³/Stunde zu fördern.

Der Wärmemesssensor der erfindungsgemäßen Vorrichtung ist vorzugsweise als NTC-Thermistor ausgeführt.

Gemäß einer weiteren bevorzugten Ausführungsform der erfindungsgemäßen Vorrichtung ist vorgesehen, dass der Wärmemesssensor alternativ als NTC-Widerstand ausgeführt ist, der funktional als Regelungsschaltung wirkt.

Die erfindungsgemäße Temperatur-Überwachungsvorrichtung für Mikroprozessoren wird im folgenden anhand einer bevorzugten Ausführungsform erläutert, die in der Figur der Zeichnung dargestellt ist. Darin zeigt:

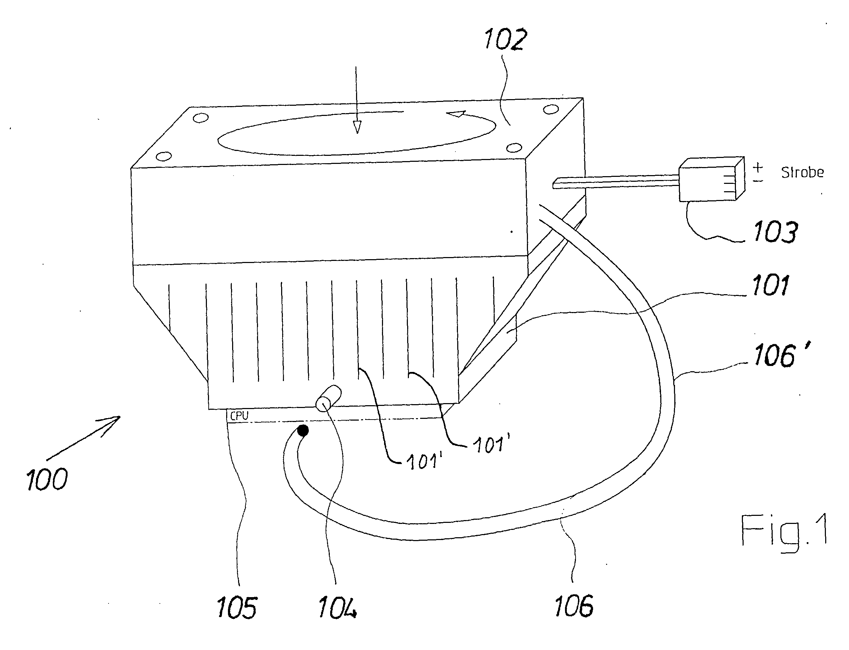

- Fig.1: eine bevorzugte Ausführungsform der erfindungsgemäßen Temperatur-Überwachungsvorrichtung in einer Ansicht von schräg oben.

Die erfindungsgemäße Temperatur-Überwachungsvorrichtung 100 für Mikroprozessoren weist eine Ventilatoreinrichtung 102 zum Erzeugen eines Luftstromes zum Kühlen eines Mikroprozessors 105 auf, wobei die Ventillatoreinrichtung auf einem mit Kühlrippen 101' versehenen massivem Block 101 angeordnet ist, der über eine gemeinsame Kontaktfläche wärmeleitend mit dem Mikroprozessor 105 verbunden ist. Die Temperatur des Mikroprozessors 105 wird mittels eines Wärmemesssensors 104 sensiert, der in einem Raumbereich nahe der Kontaktfläche des Mikroprozessors 105 mit dem Block 101 angebracht ist.

Bei der dargestellten Ausführungsform der erfindungsgemäßen ist Temperatur-Überwachungsvorrichtung 100 ist der Wärmemesssensor 104 als NTC-Widerstand ausgeführt. Dadurch ist das Vorsehen einer gesonderten Regelungsschaltung entbehrlich, da der NTC-Widerstand über Leitungen 106, 106' so in den Stromkreis der Ventilatoreinrichtung 102 geschaltet ist, dass er funktional als Regelungsschaltung wirkt.

Zusätzlich zu der Drehzahlregelung durch den als NTC-Widerstand ausgeführten Wärmemesssensor 104 ist eine Drehzahlüberwachungseinrichtung 103 zum Überwachen eines vorgebbaren Drehzahlbereiches der Ventilatoreinrichtung 102 vorgesehen, die im Zusammenwirken mit einer nicht dargestellten elektronischen Schaltung bzw. geeigneter Software ein Warnsignal abgibt, um einen Benutzer einer mit der Mikroprozessor 105 betriebenen Vorrichtung zum manuellen Abschalten derselben aufzufordern, wenn der vorgegebene Drehzahlbereich der Ventilatoreinrichtung 102 verlassen ist.

Die Ventilatoreinrichtung 102 ist so dimensioniert, dass sie eine Leistung aufzubringen in der Lage ist, um eine Luftmenge etwa 80 m³/Stunde zu fördern.

Gemäß einer anderen Ausführungsform der Vorrichtung 100 ist eine nicht dargestellte Regelungsschaltung vorgesehen, um aufgrund der von einem elektronischen Wärmemesssensor 104 sensierten Temperatur die Geschwindigkeit der Ventilatoreinrichtung 102 mit steigender Temperatur zu erhöhen oder mit sinkender Temperatur zu mindern.

Das oben erläuterte Ausführungsbeispiel der Erfindung dient lediglich dem Zweck eines besseren Verständnisses der durch die Ansprüche definierten erfindungsgemäßen Lehre, die als solche durch das Ausführungsbeispiel nicht eingeschränkt ist.

## Patentansprüche

1. Temperatur-Überwachungsvorrichtung für Mikroprozessoren, mit einer Ventilatoreinrichtung zum Erzeugen eines Luftstromes zum Kühlen des Mikroprozessors **dadurch gekennzeichnet, dass** die Temperatur des Mikroprozessors mittels eines im Bereich von dessen Oberfläche angebrachten Wärmemesssensors sensierbar ist, und eine Regelungsschaltung vorgesehen ist, die aufgrund der von dem Wärmemesssensor sensierten Temperatur die Geschwindigkeit der Ventilatoreinrichtung mit steigender Temperatur erhöht und mit sinkender Temperatur mindert, wobei zusätzlich eine Drehzahlüberwachungseinrichtung zum Überwachen eines vorgebbaren Drehzahlbereiches der Ventilatoreinrichtung vorgesehen ist, die im Zusammenwirken mit einer elektronischen Schaltung ein Warnsignal abgibt, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist.

2. Vorrichtung nach Anspruch 1, **dadurch gekennzeichnet, dass** der die Temperatur des Mikroprozessors sensierende Wärmemesssensor in einer in dem Boden eines Kühlkörpers des Mikroprozessors ausgebildeten Bohrung angeordnet ist.

3. Vorrichtung nach Anspruch 2, **dadurch gekennzeichnet, dass** die Ventilatoreinrichtung an dem Kühlkörper des Mikroprozessors angeordnet ist.

4. Vorrichtung nach einem der vorhergehenden Ansprüche, **dadurch gekennzeichnet, dass** die Drehzahlüberwachungseinrichtung zum Überwachen eines vorgebbaren Drehzahlbereiches der Ventilatoreinrichtung eine Einrichtung enthält, die ein mit der Umdrehungsfrequenz des Ventilators der Ventilatoreinrichtung getaktetes Stroboskopsignal liefert, sowie eine mit einer vorgegebenen Frequenz getaktete Einrichtung zum Auswerten des Stroboskopsignals enthält.

5. Vorrichtung nach einem der vorhergehenden Ansprüche, **dadurch gekennzeichnet, dass** die Ventilatoreinrichtung dimensioniert ist, um in der Lage zu sein, eine Luftmenge etwa 80 m³/Stunde zu fördern.

6. Vorrichtung nach einem der vorhergehenden Ansprüche, **dadurch gekennzeichnet, dass** der Wärmemesssensor als NTC-Thermistor ausgeführt ist.

7. Vorrichtung nach einem der vorhergehenden Ansprüche, **dadurch gekennzeichnet, dass** der Wärmemesssensor als NTC-Widerstand ausgeführt ist, der funktional als Regelungsschaltung wirkt.

## Geänderte Patentansprüche

### Geänderte Patentansprüche gemäss Regel 86(2) EPÜ.

**1.** Temperatur-Überwachungsvorrichtung für Mikroprozessoren, mit einer Ventilatoreinrichtung zum Erzeugen eines Luftstromes zum Kühlen des Mikroprozessors, wobei die Temperatur des Mikroprozessors mittels eines im Bereich von dessen Oberfläche angebrachten Wärmemesssensors sensierbar ist, wobei eine Drehzahlüberwachungseinrichtung zum Überwachen eines vorgebbaren Drehzahlbereiches der Ventilatoreinrichtung vorgesehen ist, die im Zusammenwirken mit einer elektronischen Schaltung ein Warnsignal abgibt, um einen Benutzer einer mit dem Mikroprozessor betriebenen Vorrichtung zum manuellen Abschalten derselben aufzufordern, wenn der vorgegebene Drehzahlbereich der Ventilatoreinrichtung verlassen ist, **dadurch gekennzeichnet, dass** eine Regelungsschaltung vorgesehen ist, die aufgrund der von dem Wärmemesssensor sensierten Temperatur die Geschwindigkeit der Ventilatoreinrichtung mit steigender Temperatur erhöht und mit sinkender Temperatur mindert.
